# EUROPEAN PATENT SPECIFICATION

(11) **EP 2 518 789 B1**
(45) Date of publication and mention of the grant of the patent: **13.04.2016**
(21) Application number: 12164273.0
(22) Date of filing: 16.04.2012
(51) Int. Cl.: H01L 51/52, H01L 33/44, H01L 33/22

(54) **Method of manufacturing a light extraction substrate for an electroluminescent device**
Herstellungsverfahren eines Lichtextraktionssubstrats für eine Elektrolumineszenzvorrichtung
Procédé de fabrication d'un substrat d'extraction de lumière pour un dispositif électroluminescent

(30) Priority: 18.04.2011 KR 20110035791; 18.04.2011 KR 20110035792
(43) Date of publication of application: 31.10.2012
(73) Proprietor: Corning Precision Materials Co., Ltd., Asan-si, Chungcheongnam-do 336-841 (KR)
(72) Inventor: Yoo, Young Zo, Chungcheongnam-do 336-841 (KR); Kim, Seo Hyun, Chungcheongnam-do 336-841 (KR); Park, Junehyoung, Chungcheongnam-do 336-841 (KR); Park, Taejung, Chungcheongnam-do 336-841 (KR); Yoon, Gun Sang, Chungcheongnam-do 336-841 (KR); Choi, Eun-Ho, Chungcheongnam-do 336-841 (KR); Park, JeongWoo, Chungcheongnam-do 336-841 (KR)
(74) Representative: Gulde & Partner

(56) References cited:
- WO-A1-98/17083
- WO-A1-2010/030045
- WO-A1-2010/033910
- WO-A1-2010/090142
- GB-A- 2 438 772
- US-A1- 2001 033 135
- US-A1- 2003 184 219

## Description

### BACKGROUND OF THE INVENTION

### Field of the Invention

The present invention relates to a method of manufacturing a light extraction substrate for an electroluminescent device, and more particularly, to a method of manufacturing a light extraction substrate for an electroluminescent device, in which light extraction efficiency can be increased.

### Description of Related Art

Electroluminescent devices are divided into inorganic electroluminescent devices and organic electroluminescent devices (OLEDs). Inorganic electroluminescent devices are represented by light-emitting diodes (LEDs).

An OLED includes an anode, an organic luminescent layer, and a cathode, which are sequentially stacked on one another. When a voltage is applied between the anode and the cathode, holes are injected from the anode into the organic luminescent layer, whereas electrons are injected from the cathode into the organic luminescent layer. Holes and electrons, which are injected into the organic luminescent layer, are bound to each other in the organic luminescent layer, thereby creating excitons. When excitons transit from the excited state to the ground state, light is emitted.

OLEDs are rapidly developing into the stage of commercial distribution, despite their relatively short history. While OLEDs have been mainly developed for display applications, recently, interest in the use of OLEDs for illumination is increasing.

However, OLEDs in the stage of commercial distribution still have a problem in that light extraction efficiency is limited to about 30% because light loss occurs at the interface due to refractive index mismatching. As a result, it is difficult to apply OLEDs to large area illumination without an improvement in the light extraction efficiency thereof.

In order to solve this problem, an OLED is provided with a light extraction layer. The light extraction layer is formed using photolithography, which in turn increases cost because of the requirement to use expensive equipment and the complicated processing. In addition, the light extraction layer formed using photolithography has many problems, such as weak force of bonding to a substrate and poor durability.

In addition, a GaN LED also needs a light extraction layer in order to increase its luminance.

The information disclosed in this Background of the Invention section is only for the enhancement of understanding of the background of the invention, and should not be taken as an acknowledgment or any form of suggestion that this information forms a prior art that would already be known to a person skilled in the art.

### BRIEF SUMMARY OF THE INVENTION

The present invention provides a method of manufacturing a light extraction substrate for an electroluminescent device, in which light extraction efficiency can be increased.

The method of the current invention provides a light extraction substrate for an electroluminescent device, which includes a substrate and a light extraction layer formed on the substrate. The light extraction layer contains an oxide that has a wide band gap of 2.8eV or more. The light extraction layer has a texture on the surface thereof.

The oxide is an inorganic oxide.

The inorganic oxide may include, as a base material, one selected from a group of substances consisting of, but not limited to, zinc oxide (ZnO), titanium dioxide (TiO₂), tin oxide (SnO₂), strontium titanate oxide (SrTiO₃), vanadium dioxide (VO₂), vanadium oxide (V₂O₃) and strontium ruthenate (SrRuO₃).

The inorganic oxide may contain a dopant that is at least one selected from a group of substances consisting of, but not limited to, magnesium (Mg), cadmium (Cd), sulfur (S), gallium (Ga), aluminum (Al), fluorine (F), manganese (Mn), cobalt (Co), copper (Cu), niobium (Nb), neodymium (Nd), strontium (Sr), tungsten (W) and iron (Fe).

The dopant may be added in an amount of 10 wt% or less.

In an exemplary embodiment, the oxide may be a zinc oxide-based oxide, and contain a dopant that is at least one selected from a group of substances consisting of, but not limited to, magnesium (Mg), cadmium (Cd), sulfur (S), gallium (Ga), aluminum (Al), tin (Sn), silicon (Si), manganese (Mn), cobalt (Co) and titanium (Ti).

In an exemplary embodiment, the refractive index of the oxide may be greater than the refractive index of the substrate.

In an exemplary embodiment, the light extraction substrate may have a haze value ranging from 2% to 100% and an average transmittance of 50% or more.

In an exemplary embodiment, the light extraction layer may be formed as a single layer or a plurality of layers, the plurality of layers being formed as homogeneous oxide layers or heterogeneous oxide layers.

In an exemplary embodiment, the thickness of the light extraction layer may range from 30nm to 4000nm.

In an exemplary embodiment, the width of the texture may be 50nm or more.

In an exemplary embodiment, the substrate may be formed as a glass, sapphire or gallium nitride (GaN) substrate.

In an exemplary embodiment, the light extraction substrate may further include an intermediate layer between the substrate and the light extraction layer.

In an exemplary embodiment, the electroluminescent device may be an organic light emitting diode (OLED) or a light-emitting diode (LED).

In an exemplary embodiment, the light extraction layer may be an external light extraction layer or an internal light extraction layer.

According to the invention provides method of manufacturing a light extraction substrate for an electroluminescent device, in which the light extraction substrate includes a substrate and a light extraction layer formed on the substrate, the light extraction layer containing an oxide that has a wide band gap of 2. 8eV or more. The light extraction layer has a texture on the surface thereof.

The method according to the current invention comprises the step of forming the light extraction layer by atmospheric pressure chemical vapor deposition (APCVD).

In an exemplary embodiment, the method may form the light extraction layer, which has the texture on the surface thereof, by carrying out an APCVD reaction with zinc (Zn) precursor gas and oxidizer gas.

The APCVD reaction may include the steps of: loading the substrate into a process chamber; heating the substrate, introducing the zinc (Zn) oxidizer gas into the process chamber, and introducing the oxidizer gas into the process chamber.

In an exemplary embodiment, the oxidizer gas may be at least one selected from the group consisting of ozone (O₃), water (H₂O), dihydrogen trioxide (H₂O₃) and alcohol (R-OH).

In an exemplary embodiment, the method may further include the step of doping the light extraction layer with a dopant during or after the APCVD.

In an exemplary embodiment, the method may further include the step of conducting plasma or chemical treatment on the substrate before the APCVD.

In an exemplary embodiment, the method may further include the step of conducting plasma or chemical treatment on the light extraction layer, which is formed after the APCVD.

According to embodiments of the invention, it is possible to increase the light extraction efficiency of the light extraction layer by forming the light extraction layer from an inorganic oxide that has high transparency, a high refractive index, a strong force of bonding to the substrate, and a wide band gap.

In addition, according to embodiments of the invention, a texture is naturally formed on the surface of the light extraction layer, which is formed by atmospheric pressure chemical vapor deposition (APCVD), thereby further simplifying the manufacturing process compared to the related art.

Furthermore, according to embodiments of the invention, it is possible to realize an inexpensive and highly efficient electroluminescent device.

The methods and apparatuses of the present invention have other features and advantages which will be apparent from, or are set forth in greater detail in the accompanying drawings, which are incorporated herein, and in the following Detailed Description of the Invention, which together serve to explain certain principles of the present invention.

### BRIEF DESCRIPTION OF THE DRAWINGS

FIG. 1 is a schematic view depicting an organic light emitting diode (OLED) including a light extraction layer according to an embodiment of the invention;
FIG. 2 to FIG. 5 are pictures obtained by photographing the surface of light extraction layers, which are manufactured according to an embodiment of the invention, using scanning electron microscopy (SEM); and
FIG. 6 to FIG. 9 are graphs sequentially depicting variations in the transmittance and haze value of the respective light extraction layers shown in FIG. 2 to FIG. 5, plotted depending on the wavelength.

### DETAILED DESCRIPTION OF THE INVENTION

Reference will now be made in detail to various embodiments of the present invention, examples of which are illustrated in the accompanying drawings and described below, so that a person having ordinary skill in the art to which the present invention relates can easily put the present invention into practice.

In the following description of the present invention, detailed descriptions of known functions and components incorporated herein will be omitted when they may make the subject matter of the present invention unclear.

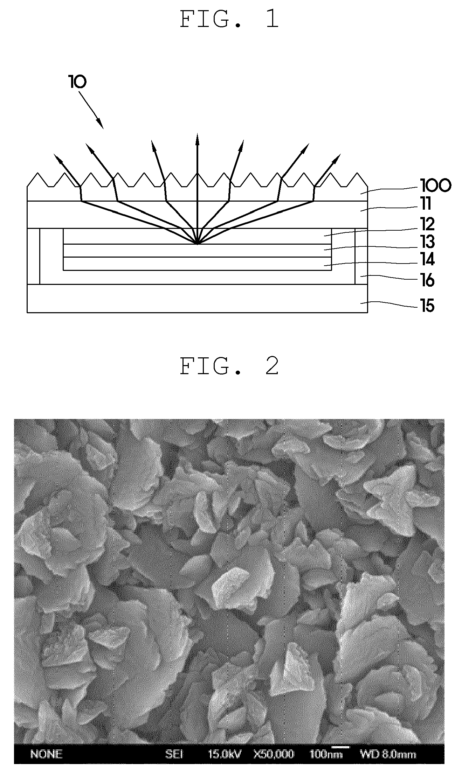

Referring to FIG. 1, a light extraction substrate for an organic light emitting diode (OLED) manufactured according to an embodiment of the invention includes a substrate 11 and a light extraction layer 100. The light extraction layer 100 is formed on the substrate 11. The light extraction layer 100 formed on the substrate 11 may have a thickness ranging from 30nm to 4000nm. In addition, the light extraction layer 100 may be implemented as an oxide thin film that has a wide band gap of 2.8eV or more. In addition, the surface of the light extraction layer 100 is also textured.

According to the invention, the light extraction layer 100 is formed using atmospheric pressure chemical vapor deposition (APCVD), but it may alternatively be formed using one process selected from among low pressure chemical vapor deposition (LPCVD), sputtering, and molecular beam epitaxy.

Here, the substrate 11 may be one of the substrates that constitute the OLED 10, the substrates being arranged such that they face each other. The OLED 10 may include a pair of substrates 11 and 15, which are arranged such that they face each other, first and second electrode layers 12 and 14, which are disposed between the substrates 11 and 15, an organic luminescent layer 13, which is disposed between the first and second electrode layers 12 and 14, and a sealing material 16, which is disposed on the outer circumference of the substrates 11 and 15 or in the space between the substrates 11 and 15 in order to protect the first and second electrode layers 12 and 14 and the organic luminescent layer 13 from the outside.

The substrate 11 is a transparent substrate that may be selected from any transparent substrates, as long as they have excellent light transmittance and excellent mechanical properties. For example, the transparent substrate can be made of a polymeric material, such as a thermally curable organic material or an ultraviolet (UV)-curable organic material, or chemically tempered glass, such as sodalime (SiO₂-CaO-Na₂O) glass or aluminosilicate (SiO₂-Al₂O₃-Na₂O) glass. The amount of Na may be adjusted depending on the application.

The light extraction layer 100 is formed as an oxide thin film that has a wide band bap of 2.8eV or more. The transparency of the oxide thin film increases with the increase in the band gap. It is preferred that the oxide thin film of the light extraction layer 100 have a refractive index that is greater than that of the substrate 11 in order to increase light extraction efficiency. The oxide thin film having such a wide band gap may be made of one or a combination of at least two selected from a group of substances consisting of, but not limited to, zinc oxide (ZnO), titanium dioxide (TiO₂), tin oxide (SnO₂), strontium titanate oxide (SrTiO₃), vanadium dioxide (VO₂), vanadium oxide (V₂O₃) and strontium ruthenate (SrRuO₃). The oxide thin film may also contain a dopant that is one or a combination of at least two selected from a group of elements consisting of, but not limited to, magnesium (Mg), cadmium (Cd), sulfur (S), gallium (Ga), aluminum (Al), fluorine (F), manganese (Mn), cobalt (Co), copper (Cu), niobium (Nb), neodymium (Nd), strontium (Sr), tungsten (W) and iron (Fe). By way of example, when the oxide is ZnO, any element selected from among Mg, Cd, S, Ga, Al, Si, F and transition metals, such as Ti, Sn, Mn, Co and Cu, may be used as the dopant. When the oxide is TiO₂, the dopant may be Nb, Nd or Sr. When the oxide is SnO₂, the dopant may be F. When the oxide is SrTiO₃, the dopant may be Nd. When the oxide is VO₂, the dopant may be W. When the oxide is SrRuO₃, the dopant may be a transition metal, such as Fe or Co. Here, the dopant elements may be used alone or in a combination of at least two thereof in order to adjust the band gap and refractive index of the respective oxides and to control the surface configuration, i.e. the texture. It is preferred that the dopant be added in an amount of 10 wt% or less. The dopant may be doped while the light extraction layer 100 is being formed, or may be doped by an additional process, such as ion implantation, after the light extraction layer 100 is formed, depending on the processing methods and processing conditions. These will be described further in the following description of a method of manufacturing the light extraction layer.

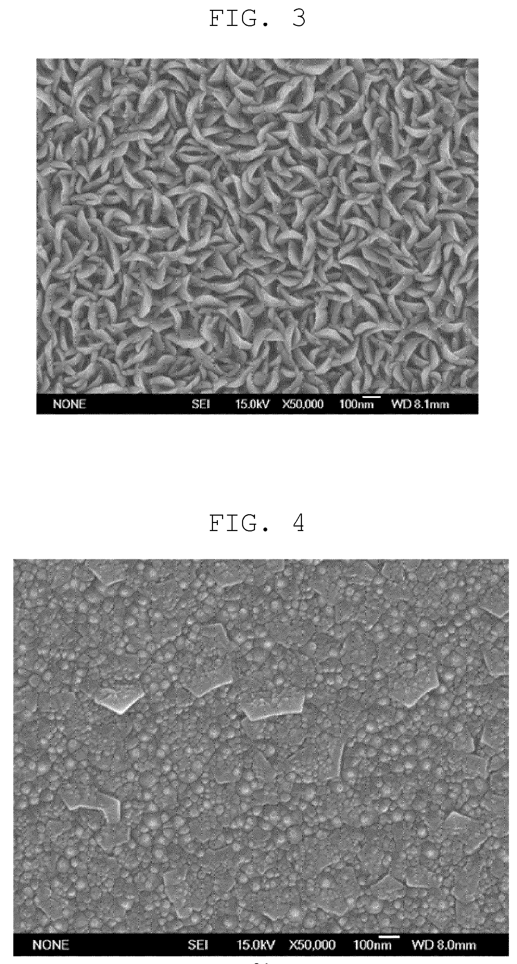

In addition, a texture that has a uniform size and shape is formed on the entire surface of the light extraction layer 100. The texture serves to diffract light in the visible range. It is preferred that the width of one particle of the texture be 50nm or more. The texture may be formed in a variety of shapes, as shown in FIG. 2 to FIG. 5.

Specifically, the light extraction layer 100 according to an embodiment of the invention exhibits a haze value ranging from 2% to 100% and an average transmittance of 50% or more in the visible light range due to the texture. Although the light extraction layer 100 is shown as having the form of a single layer in FIG. 1, it may be formed as a plurality of layers in order to further increase the light extraction efficiency.

The light extraction layer of the invention is not limited to an external light extraction layer, as shown in FIG. 1, but can also be an internal light extraction layer.

A description will be given below of the method of manufacturing the light extraction layer for an electroluminescent device according to an exemplary embodiment of the invention.

The method of manufacturing the light extraction layer for an electroluminescent device of this exemplary embodiment forms the light extraction layer 100, which is made of an inorganic oxide that has a wide band gap of 2.8eV or more, on the substrate by an atmosphere pressure chemical vapor deposition (APCVD) process. When the light extraction layer 100 is formed due to an APCVD reaction, a texture is naturally formed on the surface thereof during the deposition. That is, the formation of the light extraction layer 100 due to the APCVD reaction can exclude processing that is added to form the texture, thereby simplifying the entire process. This can consequently increase productivity and help realize mass production.

This APCVD process may include the steps of, for example, loading the substrate, heating the substrate, introducing precursor gas, and introducing oxidizer gas, carried out in this sequence.

First, in the step of loading the substrate, the substrate 11 is loaded into a process chamber (not shown) in which the APCVD reaction is carried out, so that the substrate 11 is placed in position inside the process chamber.

After the substrate 11 is loaded into the process chamber (not shown), it is heated to a predetermined temperature. In the heating step, the substrate 11 may be heated to a temperature ranging from 170°C to 520°C.

In the subsequent step of introducing the precursor gas, zinc (Zn) precursor gas is introduced into the process chamber (not shown), in which the substrate 11 is loaded, in order to deposit a zinc oxide (ZnO) thin film, which constitutes the light extraction layer 100, on the substrate 11. The precursor gas can be carried by a carrier gas, which is composed of inert gases such as nitrogen, helium and argon, into the process chamber (not shown).

In the final step of introducing the oxidizer gas, the oxidizer gas is introduced into the process chamber (not shown) for an APCVD reaction with the precursor gas. The oxidizer may be one or a combination of at least two selected from the group consisting of, but not limited to, ozone (O₃), water (H₂O), dihydrogen trioxide (H₂O₃) and alcohol (R-OH).

The step of introducing the precursor gas and the step of introducing the oxidizer gas may both be carried out at the same time. In this case, it is preferred that the respective gases be controlled such that they are supplied along different paths in order to prevent the gases from mixing with each other before being introduced into the process chamber (not shown). In addition, the precursor gas and the oxidizer gas may be preheated before being supplied in order to activate a chemical reaction.

In order to control the shape of the texture that is created on the surface of the light extraction layer 10 when the light extraction layer 100 is deposited by the APCVD process, the surface of the substrate 11 may be reformed by conducting plasma or chemical treatment thereon before the APCVD process. Alternatively, in order to control the shape of the texture that is created on the surface of the light extraction layer 10 when the light extraction layer 100 is deposited by the APCVD process, the surface of the light extraction layer 100, which is formed after the APCVD process, may be reformed by conducting plasma or chemical treatment thereon.

After the foregoing process is completed, the light extraction layer 100 for an electroluminescent device according to an embodiment of the invention is formed.

As can be seen from the photographs taken using scanning electron microscopy (SEM) shown in FIG. 2 to FIG. 5, a variety of shapes of textures having a uniform overall size is formed on the surface of the light extraction layers 100, which are manufactured according to an embodiment of the invention, depending on process conditions. The thickness of the light extraction layers 100 ranges from 30nm to 4000nm, and the width of the textures is 50nm or more.

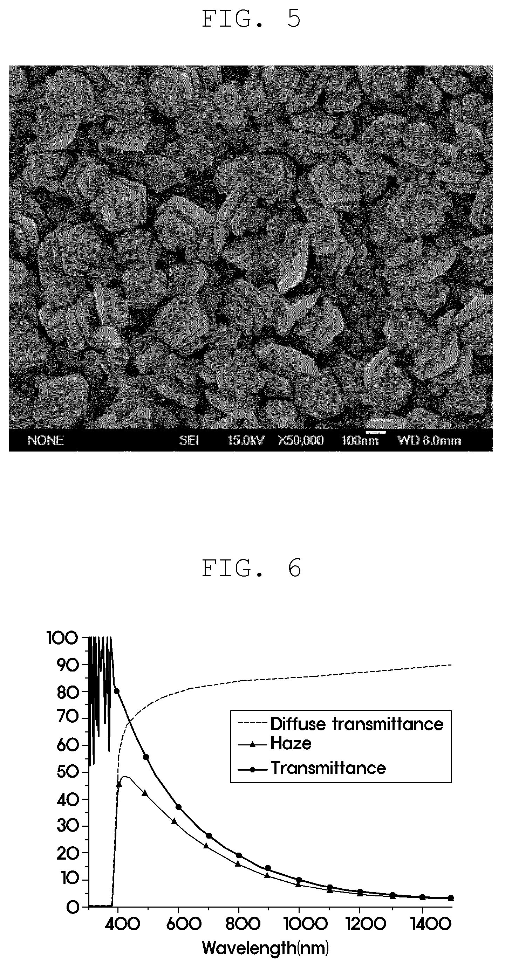

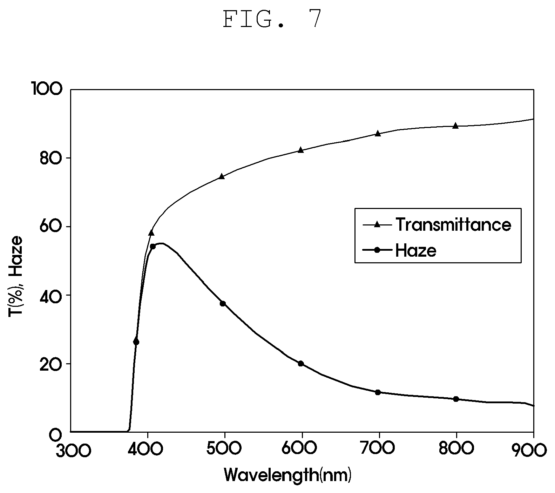

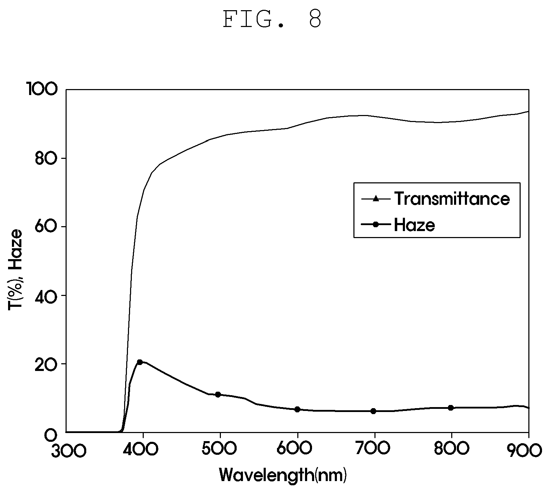

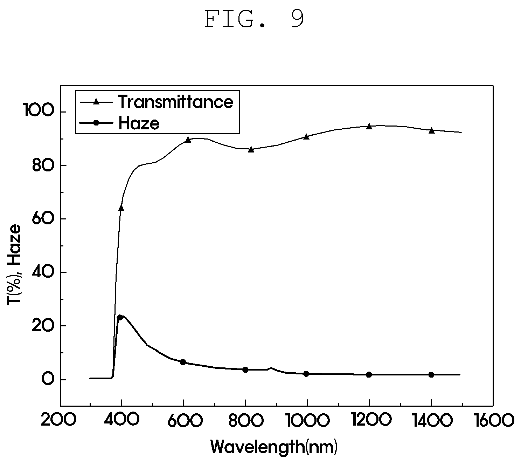

FIG. 6 to FIG. 9 are graphs sequentially depicting variations in the transmittance and haze value of the respective light extraction layers shown in FIG. 2 to FIG. 5, plotted depending on the wavelength, the light extraction layers being manufactured based on different process conditions. As shown in these graphs, it was observed that the light extraction layers 100 for an electroluminescent device, which are manufactured according to an embodiment of the invention, exhibit a relatively high haze value and an average transmittance of 50% or more in the visible light range.

As described above, embodiments of the invention provide a method of manufacturing the light extraction layer for an electroluminescent device, in which the light extraction efficiency of the light extraction layer 100 can be increased by forming the light extraction layer 100 from an inorganic oxide that has high transparency, a high refractive index, a strong force of bonding to the substrate 11, and a wide band gap. In addition, embodiments of the invention provide methods of manufacturing the light extraction layer for an electroluminescent device, in which the manufacturing process can be simplified compared to the related art due to the natural formation of the texture on the surface of the light extraction layer 100. Accordingly, an inexpensive and highly efficient electroluminescent device 10 can be realized.

Table 1 below shows effects of a material of a light extraction layer.

**[Table 1]**

| | Light extraction layer of inorganic material | Light extraction layer of organic material |
|---|---|---|
| Refractive index | 2.0 or more | 1.7 or less |
| Durability | High strength | Low strength |
| Method | CVD | Lamination |
| Coupling with Glass | Chemical bonding | Physical coupling |

The foregoing descriptions of specific exemplary embodiments of the present invention have been presented with respect to the certain embodiments and drawings. They are not intended to be exhaustive or to limit the invention to the precise forms disclosed, and obviously many modifications and variations are possible for a person having ordinary skill in the art in light of the above teachings.

The scope of the invention is defined by the Claims appended hereto.

## Claims

1. A method of manufacturing a light extraction substrate for an electroluminescent device, wherein the light extraction substrate comprises:
a substrate; and
a light extraction layer formed on the substrate, the light extraction layer containing an inorganic oxide that has a wide band gap of 2.8eV or more, wherein the light extraction layer has a texture on a surface thereof **characterized in that** the light extraction layer is formed by atmospheric pressure chemical vapor deposition (APCVD) and the said texture is formed during the APCVD deposition.

2. The method of claim 1, comprising forming the light extraction layer which has the texture on the surface thereof, by carrying out the atmospheric pressure chemical vapor deposition (APCVD) with zinc (Zn) precursor gas and oxidizer gas.

3. The method according to claim 2, wherein the atmospheric pressure chemical vapor deposition (APCVD) comprises:
loading the substrate into a process chamber;
heating the substrate;
introducing the zinc (Zn) precursor gas into the process chamber; and
introducing the oxidizer gas into the process chamber.

4. The method according to claim 2 or 3, wherein the oxidizer gas comprises at least one selected from the group consisting of O₃, H₂O, H₂O₃ and an alcohol.

5. The method according to claim 1, further comprising doping the light extraction layer with a dopant during or after the atmospheric pressure chemical vapor deposition (APCVD).

6. The method according to claim 1, comprising conducting plasma or chemical treatment on the substrate before the atmospheric pressure chemical vapor deposition (APCVD).

7. The method according to claim 1, comprising conducting plasma or chemical treatment on the light extraction layer, which is formed by the atmospheric pressure chemical vapor deposition (APCVD).

## Patentansprüche

1. Herstellungsverfahren eines Lichtextraktionssubstrats für eine Elektrolumineszenzvorrichtung, wobei das Lichtextraktionssubstrat Folgendes umfasst:
ein Substrat und
eine auf dem Substrat ausgebildete Lichtextraktionsschicht, wobei die Lichtextraktionsschicht ein anorganisches Oxid beinhaltet, das einen breiten Bandabstand von 2,8 eV oder mehr aufweist, wobei die Lichtextraktionsschicht auf einer Oberfläche derselben eine Textur aufweist, **dadurch gekennzeichnet, dass** die Lichtextraktionsschicht durch chemische Gasphasenabscheidung bei Atmosphärendruck (APCVD) ausgebildet wird und dass die Textur während der APCVD ausgebildet wird.

2. Verfahren nach Anspruch 1, umfassend das Ausbilden der Lichtextraktionsschicht, die auf der Oberfläche derselben die Textur aufweist, durch Ausführen der chemischen Gasphasenabscheidung bei Atmosphärendruck (APCVD) mit Zink (Zn)-Vorläufergas und Oxidatorgas.

3. Verfahren nach Anspruch 2, wobei die chemische Gasphasenabscheidung bei Atmosphärendruck (APCVD) Folgendes umfasst:
Einführen des Substrats in eine Prozesskammer;
Erhitzen des Substrats;
Zuführen des Zink (Zn)-Vorläufergases in die Prozesskammer und
Zuführen des Oxidatorgases in die Prozesskammer.

4. Verfahren nach Anspruch 2 oder 3, wobei das Oxidatorgas zumindest eines, ausgewählt aus der Gruppe bestehend aus O₃, H₂O, H₂O₃ und einem Alkohol, umfasst.

5. Verfahren nach Anspruch 1, ferner umfassend das Dotieren der Lichtextraktionsschicht mit einem Dotierstoff während oder nach der chemischen Gasphasenabscheidung bei Atmosphärendruck (APCVD).

6. Verfahren nach Anspruch 1, umfassend das Ausführen einer Plasmabehandlung oder einer chemischen Behandlung des Substrats vor der chemischen Gasphasenabscheidung bei Atmosphärendruck (APCVD).

7. Verfahren nach Anspruch 1, umfassend das Ausführen einer Plasmabehandlung oder einer chemischen Behandlung der Lichtextraktionsschicht, die durch die chemische Gasphasenabscheidung bei Atmosphärendruck (APCVD) ausgebildet wird.

## Revendications

1. Procédé de fabrication d'un substrat d'extraction de lumière pour un dispositif électroluminescent, où le substrat d'extraction de lumière comprend :
un substrat ; et
une couche d'extraction de lumière formée sur le substrat, ladite couche d'extraction de lumière contenant un oxyde inorganique à large bande interdite de 2,8eV ou plus, ladite couche d'extraction de lumière étant texturée sur une surface, **caractérisé en ce que** la couche d'extraction de lumière est formée par dépôt chimique en phase vapeur sous pression atmosphérique (APCVD) et **en ce que** la texture est formée pendant le dépôt APCVD.

2. Procédé selon la revendication 1, comprenant la formation de la couche d'extraction de lumière dont la surface est texturée par exécution du dépôt chimique en phase vapeur sous pression atmosphérique (APCVD) avec un gaz précurseur de zinc (Zn) et un gaz oxydant.

3. Procédé selon la revendication 2, où le dépôt chimique en phase vapeur sous pression atmosphérique (APCVD) comprend :
le chargement du substrat dans une chambre de processus ;
le chauffage du substrat ;
l'introduction du gaz précurseur de zinc (Zn) dans la chambre de processus ; et
l'introduction du gaz oxydant dans la chambre de processus.

4. Procédé selon la revendication 2 ou la revendication 3, où le gaz oxydant comprend au moins un composé sélectionné dans le groupe comprenant O₃, H₂O, H₂O₃, et un alcool.

5. Procédé selon la revendication 1, comprenant en outre le dopage de la couche d'extraction de lumière par un dopant pendant ou après le dépôt chimique en phase vapeur sous pression atmosphérique (APCVD).

6. Procédé selon la revendication 1, comprenant l'application de plasma ou d'un traitement chimique sur le substrat avant le dépôt chimique en phase vapeur sous pression atmosphérique (APCVD).

7. Procédé selon la revendication 1, comprenant l'application de plasma ou d'un traitement chimique sur la couche d'extraction de lumière formée par le dépôt chimique en phase vapeur sous pression atmosphérique (APCVD).
